# EUROPEAN PATENT APPLICATION

(11) **EP 1 703 569 A2**
(43) Date of publication of application: **20.09.2006**
(21) Application number: 06251231.4
(22) Date of filing: 08.03.2006
(51) Int. Cl.: H01L 31/0352, H01L 31/18

(54) **High efficiency inorganic nanorod-enhanced photovoltaic devices**

(30) Priority: 16.03.2005 US 81967
(71) Applicant: GENERAL ELECTRIC COMPANY, Schenectady, NY 12345 (US)
(72) Inventor: Tsakalakos, Loucas, New York 12309 (US); Korman, Charles Steven, New York 12309 (US); Ebong, Abasifreke, Georgia 30062 (US); Srivastava, Alok Mani, New York 12309 (US); Lee, Ji-ung, New York 12309 (US); Leboeuf, Steven, New York 12309 (US); Wojnarowski, Robert, New York 12019 (US); Sulima, Oleg, Delaware 19711 (US)
(74) Representative: Pedder, James Cuthbert

(57) **Abstract**

The present invention is directed to photovoltaic devices comprising nanostructured materials, wherein such photovoltaic devices are comprised exclusively of inorganic components. Depending on the embodiment, such nanostructured materials are either 1-dimensional nanostructures or branched nanostructures, wherein such nanostructures are used to enhance the efficiency of the photovoltaic device, particularly for solar cell applications. Additionally, the present invention is also directed at methods of making and using such devices.

## Description

The present invention relates generally to photovoltaic devices, and specifically to photovoltaic devices comprising nanostructured materials.

Presently, silicon (Si) is the most commonly used material in the fabrication of solar cells, such solar cells being used for converting sunlight into electricity. Single and multi-junction p-n solar cells are used for this purpose, but none are efficient enough to drive down the costs involved in the production and use of this technology. Consequently, competition from conventional sources of electricity precludes the widespread use of such solar cell technology.

The primary loss process in existing solar cells occurs when a photo-excited electron-hole pair quickly looses any energy it may have in excess of the bandgap. This loss alone limits the conversion efficiency of a standard cell to about 44%. Additionally, recombination of such photo-excited electron-hole pairs reduces the efficiency further. Although this latter reduction in efficiency can be overcome by using other materials with appropriate properties, particularly long diffusion lengths of the photo-generated carriers, this still does not bring this technology to a cost parity with more conventional sources of electricity. With all of the photovoltaic losses taken into account, Shockley and Queisser were able to show that the performance of a single junction cell was limited to just over 30 percent efficiency for an optimal cell with a bandgap of 1.3 electron volts (eV) (W. Shockley and H.J. Queisser, "Detailed Balance Limit of Efficiency of p-n Junction Solar Cells," J. Appl. Phys., 1961, 32(3), pp. 510-519). More recent calculations have shown this "limit efficiency" for a single junction to be 29 percent (M.J. Kerr et al., "Lifetime and efficiency of limits of crystalline silicon solar cells," Proc. 29th IEEE Photovoltaic Specialists Conference, 2002, pp. 438-441).

Recent developments in multi-junction technologies are costly and not enough to justify a shift to photovoltaic (PV) technology in homes or industries.

Additionally, the incorporation of nanostructures into such devices has thus far failed to achieve efficiencies sufficient to make such solar power technologies economically viable.

Kalkan et al., in United States Patent Publication No. US 2002/0192441, have described electronic and optoelectronic devices comprising interpenetrating nanostructured thin films and organic semiconductors, wherein the nanostructured thin films possess continuous electrical conduction pathways to a substrate electrode. Suitable materials proposed are CdSe nanocrystals and poly(2-methoxy, 5-(2'-ethyl-hexyloxy)-p-phenylenevinylene), a semiconducting polymer.

United States Patent Publication No. US 2004/0003839 describes a nanostructured photovoltaic device similar to that above, wherein the void space is filled with adhesive. In this work, dimensions are not given, but the manner of making such devices (i.e., pouring molten precursor materials into dies) precludes dimensions below several hundred nanometers.

Silicon nanowires have been described in p-n junction diode arrays (Peng et al., "Fabrication of large-Area Silicon Nanowire p-n Junction Diode Arrays," Adv. Mater., 2004, vol. 16, pp. 73-76). Such arrays, however, were not configured for use in photovoltaic devices, nor was it suggested how such arrays might serve to increase the efficiency of solar cells.

Silicon nanostructures have been described in solar cell devices (Ji et al., "Silicon Nanostructures by Metal Induced Growth (MIG) for Solar Cell Emitters," Proc. IEEE, 2002, pp. 1314-1317). In such devices, Si nanowires can be formed, embedded in microcrystalline Si thin films, by sputtering Si onto a nickel (Ni) pre-layer, the thickness of which determines whether the Si nanowires grow inside the film or not. However, such nanowires are not active PV elements; they merely serve in an anti-reflective capacity.

As a result of the above-described limitations of existing PV technology, any modifications of such technology, particularly modifications incorporating nanoscale materials and devices, that lead to efficiencies on par with the more traditional sources of electricity, would be entirely beneficial.

In some embodiments, the present invention is directed to photovoltaic devices comprising nanostructured materials. Additionally, the present invention is also directed at methods of making and using such devices. Generally, such devices can be viewed as being integrated nanostructured devices.

In some embodiments, the present invention is directed to a photovoltaic device comprising: (a) a substrate; (b) a first region comprising an array of 1-dimensional nanostructures positioned on the substrate in a substantially vertical orientation; (c) a second region residing on top of the first region such that contact of the first and second regions forms at least one charge separating junction; (d) a third region comprising a conductive transparent material residing as a layer on top of the second region; and (e) top and bottom contacts operable for connecting the device to an external circuit, wherein the bottom contact is in electrical contact with the first region and the top contact is in electrical contact with the second region. Such devices generally have first, second, and third regions that are comprised exclusively of inorganic materials/components.

In some embodiments, the present invention is directed to a method of making a photovoltaic device comprising the steps of: (a) forming a first region on a substrate, wherein the first region comprises an array of 1-dimensional nanostructures that are oriented on the substrate in a substantially perpendicular fashion; (b) establishing a second region of material to the top of the first region such that contact of the first and second regions forms at least one charge separating junction; (c) providing a third region, comprising an optically transparent conductive material, on top of the second region; and (d) providing top and bottom contacts operable for connecting the device to an external circuit, wherein the bottom contact is in electrical contact with the first region and the top contact is in electrical contact with the second region.

In some embodiments, the present invention is directed to a photovoltaic device comprising: (a) a substrate; (b) a first region comprising an array of branched nanostructures of semiconducting material positioned on the substrate, wherein charge separating junctions exist within such branched nanostructures; (c) a second region comprising a conductive transparent material residing as a layer on top of the first region; wherein the first and second regions are comprised exclusively of inorganic components; and (d) top and bottom contacts operable for connecting the device to an external circuit.

In some embodiments, the devices of the present invention are used as sources of power in residential and commercial infrastructures. In some or other embodiments, these devices are used as power supplies in portable equipment. In other embodiments, satellite power panels utilize this technology to reduce size and weight, and increase reliability, of space-deployed electrical photovoltaic panels.

The invention will now be described in greater detail, by way of example, with reference to the drawings, in which:-
FIGURE 1 depicts fabrication of doped silicon (Si) nanorod arrays on a thin Si substrate, in accordance with an embodiment of the present invention;
FIGURE 2 depicts fabrication of doped nanorod arrays on a thin, high-temperature metal foil, in accordance with an embodiment of the present invention;
FIGURE 3 depicts a variation of the embodiment depicted in FIGURE 2, wherein the dielectric layer is deposited with a graded index of refraction;
FIGURE 4 depicts fabrication of a photovoltaic device comprising an array of nanorods and further comprising micro-scale optical focusing features;
FIGURE 5 depicts fabrication of a photovoltaic device comprising an array of micro-lenses fabricated directly above the photovoltaic device;
FIGURE 6 depicts an alternative embodiment where a nanorod array is first fabricated on an oxide substrate that is subsequently removed;
FIGURE 7 depicts stepwise growth of Si nanorods on a surface structured with pyramids;
FIGURE 8 depicts a low-resistance nanorod photovoltaic cell with two TCO layers divided by an insulating layer;
FIGURE 9 depicts stepwise growth of a first TCO layer, wherein the insulating and second TCO layers are grown in the same way;
FIGURE 10 depicts a photovoltaic cell comprising a structured surface in accordance with an embodiment of the present invention;
FIGURE 11 depicts a nano-hybrid photovoltaic cell in accordance with an embodiment of the present invention;
FIGURE 12 depicts a photovoltaic cell comprising heterojunction nanorod arrays in accordance with an embodiment of the present invention;
FIGURE 13 depicts an SEM image of a nanowire array formed by wet etching on a <100> Si wafer;
FIGURE 14 depicts an SEM image of a nanowire array formed by wet etching on a <111> Si wafer
FIGURE 15 illustrates reflectance measurements over a range of wavelengths for PV cells with (◆) and without (▲) nanowires;
FIGURE 16 illustrates specular reflectance measurements over a range of wavelengths for PV cells with nanowires;
FIGURE 17 is an SEM image depicting a CVD-produced Si nanowire array grown at 560°C;
FIGURE 18 is an SEM image depicting a cross-section of Si nanowires, arrayed substantially perpendicular to the substrate on which they reside, wherein the Si nanowires comprise p-n junctions within each nanowire;
FIGURE 19 is an I-V curve depicting the dark current voltage of a nanowire array solar cell;
FIGURE 20 depicts both the dark I-V curve and the I-V characteristics of a nanowire array solar cell under irradiation from a ceramic metal halide lamp
FIGURE 21 depicts the photoresponse of individual nanowires having photocurrents of 10-200 picoamperes;
FIGURE 22 is an I-V curve of an individual Si nanowire containing a p-n diode;
FIGURE 23 depicts the fabrication of two layers of branched nanowire arrays of alternate doping on a silicon substrate in accordance with embodiments of the present invention
FIGURE 24 depicts the placement of a phosphor layer on a PV device in accordance with an embodiment of the present invention; and
FIGURE 25 is an SEM image depicting an example of a CVD-produced Si nanowire array grown in a nanoporous anodic aluminum oxide (AAO) template..

In the following description, specific details are set forth such as specific quantities, sizes, etc. so as to provide a thorough understanding of embodiments of the present invention. However, it will be obvious to those skilled in the art that the present invention may be practiced without such specific details. In many cases, details concerning such considerations and the like have been omitted inasmuch as such details are not necessary to obtain a complete understanding of the present invention and are within the skills of persons of ordinary skill in the relevant art.

Referring to the drawings in general, it will be understood that the illustrations are for the purpose of describing a particular embodiment of the invention and are not intended to limit the invention thereto.

While most of the terms used herein will be recognizable to those of skill in the art, the following definitions are nevertheless put forth to aid in the understanding of the present invention. It should be understood, however, that when not explicitly defined, terms should be interpreted as adopting a meaning presently accepted by those of skill in the art.

A "1-dimensional nanostructure," as defined herein, refers to nanotubes, nanorods, nanocylinders, and nanowires of inorganic composition, generally having sub-micron diameters and typically having diameters below 300 nm, and wherein their 1-dimensionality originates from their large aspect ratios.

An "intrinsic semiconductor" or "i-type semiconductor," as defined herein, refers to a nearly pure semiconductor that has nearly equal concentrations of electrons and holes under conditions of thermal equilibrium, and that does not contain impurities that could dope the semiconductor.

A "doped semiconductor," as defined herein, refers to a semiconductor that has an added impurity. Typically, such impurities are chosen so as to render the doped semiconductor either "p-doped" or "n-doped," wherein the doped semiconductor has "acceptor" or "donor" impurities, respectively.

A "charge separating junction," according to the present invention, is a junction created when two materials of opposite polarity meet. In "p-n junctions," these two materials are p- and n-doped semiconductors. When the p-n junctions are formed by doped semiconductors of dissimilar bulk composition, they are termed "p-n heterojunctions." When p- and n-doped semiconductor material sandwich an i-type semiconductor material, a "p-i-n junction" results. Lastly, when a doped semiconductor forms a junction with a metal, a "Schottky junction" is formed.

A "photovoltaic effect," as defined herein, is an effect arising when a junction (e.g., p-n) between two dissimilar materials, such as a metal and a semiconductor or two opposite polarity semiconductors, is exposed to electromagnetic (EM) radiation. A forward voltage appears across the illuminated junction and power can be delivered from it to an external circuit. The effect results from the depletion region and resulting potential barrier invariably associated with an unbiased junction. Such an effect is utilized in "photovoltaic devices" (e.g., solar cells) in order to produce an electromotive force (e.m.f.).

A "heterogeneous composition," as defined herein, generally refers to a material that is non-uniform throughout.

A "graded bandgap," as defined herein, refers to doped semiconductor material that possesses graded level of chemical composition in at least one direction.

A "tunneling barrier," as defined herein, refers to a barrier to electron flow through which electrons must "tunnel." Such "tunneling" is a quantum mechanical phenomenon in which electrons, based on probability considerations, can overcome barriers that they have insufficient energy to cross.

"Wet etching," as defined herein, refers to the dissolution and removal of material via solution-based chemistries.

"Templating compounds," as defined herein, are molecules or macromolecules that are capable of "self assembly" and, once assembled, can serve as templates for the growth of 1-dimensional nanostructures, typically via solution-based chemical processes.

"Nanotemplates," as defined herein, are inorganic or organic films comprising an array of pores or columns having nanoscale dimensions.

The present invention is generally directed to photovoltaic (PV) devices comprising integrated nanostructured regions. In such regions, nanostructures can be arrayed and form massively parallel p-n devices, which can vary in density as chosen by the requirements of the design. Additionally, the present invention is also directed at methods of making and using such devices.

In some embodiments, the present invention is directed to a photovoltaic device comprising: (a) a substrate; (b) a first region comprising an array of 1-dimensional nanostructures positioned on the substrate in a substantially vertical orientation; (c) a second region residing on top of the first region such that contact of the first and second regions forms at least one charge separating junction; (d) a third region comprising a layer of conductive transparent material residing on top of the second region; and (e) top and bottom contacts operable for connecting the device to an external circuit, wherein the bottom contact is in electrical contact with the first region and the top contact is in electrical contact with the second region. The first, second, and third regions of such devices may be comprised exclusively of inorganic components, and substrates can be of any suitable inorganic material including, but not limited to, metal, semiconductor, doped semiconductor, amorphous dielectric (e.g., glasses), crystalline dielectric, and combinations thereof.

Substantially vertical, according to the present invention, means that the 1-dimensional nanostructures are positioned on the substrate such that their 1-dimensional length forms an angle with the substrate that is between 90° and 45°.

In some of the above-described embodiments, the 1-dimensional nanostructures of the first region comprise doped semiconductor nanowires, wherein the doped semiconductor nanowires comprise a doping selected from the group consisting of p-doping, n-doping, and combinations thereof. In some or other embodiments, the 1-dimensional nanostructures are semiconductor nanowires comprising semiconducting material selected from the group consisting of silicon, GaAs, GaP, InP, GaInP, Ge, GaInAs, AlGaAs, ZnO, GaN, AIN, InN, BN, Se, CdSe, CdTe, Cd-O-Te, Cd-Mn-O-Te, ZnTe, Zn-O-Te, Zn-Mn-O-Te, MnTe, Mn-O-Te, oxides of copper, carbon, Cu-In-Ga-Se, Cu-In-Se, and combinations thereof.

In some of the above-described embodiments, the second region comprises a conformal layer of material selected from the group consisting of p-doped semiconductor, n-doped semiconductor, intrinsic semiconductor, metal, and combinations thereof. Such conformal layers can be amorphous, crystalline, or combinations thereof.

In some of the embodiments described above, the second region exists as extensions of the 1-dimensional nanostructures of the first region, wherein the first and second regions collectively form an array of 1-dimensional nanostructures. In some embodiments, at least some of the 1-dimensional nanostructures within such an array comprise multiple charge separating junctions. In some embodiments, at least some of the 1-dimensional nanostructures comprise a graded bandgap. In some embodiments, at least some of the 1-dimensional nanostructures comprise multiple segments of varying bandgap. In some embodiments, at least some of the 1-dimensional nanostructures comprise at least one tunneling barrier. In some such embodiments, contact of the first and second regions forms at least one heterojunction.

In some of the above-described device embodiments, at least one of the first and second regions comprise heterogeneous sub-regions, wherein the sub-regions are heterogeneous by virtue of a property selected from the group consisting of heterogeneous doping, heterogeneous composition, and combinations thereof.

In some of the above-described device embodiments, the charge separating junctions are selected from the group consisting of heterojunctions, p-n junctions, multiple p-n heterojunctions, p-i-n junctions, Schottky junctions, and combinations thereof.

In some of the above-described embodiments, the conductive transparent material is selected from the group consisting of indium-tin-oxide glass (ITO), Ga-In-Sn-O (GITO), Zn-In-Sn-O (ZITO), Ga-In-O (GIO), Zn-In-O (ZIO), and combinations thereof.

In some embodiments, the density of the 1-dimensional nanostructures within the photovoltaic device is from between about 10³ nanostructures per cm² to about 10¹² nanostructures per cm². Alternatively, the density of the 1-dimensional nanostructures can be described such that they occupy a volume of the first region that is between about 5 percent and about 100 percent. In some embodiments, the density of the 1-dimensional nanostructures is optimized to minimize shading effects.

Typically, the 1-dimensional nanostructures used in the above-described photovoltaic devices have a diameter between about 1 nm and about 300 nm. They also typically have a height between about 50 nm and about 50 µm. In some embodiments, the 1-dimensional nanostructures vary in height and diameter within the array.

In some embodiments, the above-described photovoltaic device further comprises a plurality of microlenses arrayed on top of the layer of the third region. In some embodiments, the substrate of such devices comprises a structured surface effective for reducing reflection, thus increasing light absorption and efficiency.

In some embodiments, the present invention is directed to a method of making a photovoltaic device comprising the steps of: (a) forming a first region on a substrate, wherein the first region comprises an array of 1-dimensional nanostructures that are positioned on the substrate in a substantially perpendicular orientation; (b) establishing a second region of material to the top of the first region such that contact of the first and second regions forms at least one charge separating junction; (c) providing a third region, comprising a layer of optically transparent conductive material, on top of the second region; and (d) providing top and bottom contacts operable for connecting the device to an external circuit, wherein the bottom contact is in electrical contact with the first region and the top contact is in electrical contact with the second region. Substrate selection can include substrates of any suitable inorganic material including, but not limited to, metal, semiconductor, doped semiconductor, amorphous dielectric (e.g., glasses), crystalline dielectric, and combinations thereof.

In some of the above-described embodiments, the step of forming the first region comprises a wet etching of a semiconductor material. In some of these embodiments, the steps of forming the first region and establishing the second region comprise wet etching of a planar silicon p-n junction with an aqueous hydrofluoric acid solution comprising an oxidant, such as silver nitrate, to provide a first region of doped silicon nanowires arrayed on a commonly doped silicon substrate and a second region of alternatively doped silicon nanowires, the alternatively doped silicon nanowires being extensions of the doped silicon nanowires of the first region and collectively forming an array of heterojunction 1-dimensional silicon nanostructured wires. In some or other embodiments, the step of forming the first region involves a self-assembly of templating compounds, wherein the templating compounds direct a solution-based growth of doped 1-dimensional inorganic nanostructures. In some embodiments, such templating compounds are selected from the group consisting of polymers, oligomers, surfactants, oligonucleotides, DNA, RNA, polypeptides, proteins, viruses, and combinations thereof. In some of these embodiments, a step of heat treating the 1-dimensional inorganic nanostructures is added to form high-quality crystalline doped 1-dimensional inorganic nanostructures.

In some of the above-described embodiments, the step of forming the first region comprises a dry etching of a semiconductor material. Examples of suitable dry etching techniques include, but are not limited to, reactive ion etching (RIE), inductively coupled plasma (ICP) etching, and combinations thereof. Additionally, mask etching and laser ablative patterning can also be used.

In some of the above-described embodiments, the step of forming a first region on a substrate further comprises the steps of: (a) establishing metal catalyst nanoparticles on the substrate; and (b) growing 1-dimensional nanostructures from the metal catalyst nanoparticles using a deposition method selected from the group consisting of chemical vapor deposition (CVD), laser ablation, molecular beam epitaxy (MBE), atomic layer deposition, and combinations thereof. In some or other embodiments, the step of establishing metal catalyst nanoparticles on the substrate further comprises the steps of: (a) depositing a metal catalyst film on the substrate; and (b) annealing of the metal catalyst film to form metal catalyst nanoparticles.

In some embodiments, the above-described step of establishing metal catalyst nanoparticles on the substrate involves a deposition of such nanoparticles onto the substrate from a liquid suspension of such nanoparticles. In some or other embodiments, the step of establishing metal catalyst nanoparticles on the substrate involves a deposition of catalyst metal in nanometer-sized pores in the substrate surface. In still other embodiments, the step of establishing metal catalyst nanoparticles on the substrate involves a deposition of metal-containing organic nanoclusters that can be thermolyzed to yield metal nanoparticles. Suitable metals include, but are not limited to, Au, Fe, Co, Ni, Ti, Cr, Cu, Al, Ga, In, Pd, Pt, Zn, Nb, Mo, Ag, Ir, Ta, and combinations and alloys thereof.

In some of the embodiments, the step of growing involves the sequential use of various deposition precursors to further establish the second region and yield an array of 1-dimensional nanostructures of heterogeneous composition. In some embodiments, the first and second regions comprise sub-regions of heterogeneous composition, wherein such heterogeneous composition comprises tunneling barriers. In some embodiments, heterogeneous doping is used to form multiple heterojunctions within the 1-dimensional nanostructures.

In some embodiments, the layer of the third region comprises material selected from the group consisting of indium-tin-oxide glass (ITO), Ga-In-Sn-O (GITO), Zn-In-Sn-O (ZITO), Ga-In-O (GIO), Zn-In-O (ZIO), and combinations thereof. In some embodiments, microlenses are added to the layer of the third region. In some embodiments, electrical contacts are added to the device in order for it to be connected to an outside circuit.

In some embodiments, the devices of the present invention are used as sources of power in residential and commercial infrastructures. In some or other embodiments, these devices are used as power supplies in portable equipment. In some embodiments the devices are used in an application selected from the group consisting of power generation on residential building rooftops, power generation on commercial building rooftops, utility power generation, consumer electronics power generation, solar energy based hydrogen production, power generation for transportation vehicles and systems, and combinations thereof.

In the discussion that follows, many embodiments are described in terms of silicon (Si) nanorods and nanowires. Nevertheless, it should be understood that the scope of the present invention extends beyond such Si nanorods and nanowires. For example, GaAs, InP, or SiC may be used as the substrate depending on the application of choice. Other nanorod materials include p- and n-doped InP, GaAs, SiC, GaN, etc.

A fundamental basis for the 1-dimensional nanostructure-based devices of the present invention is the fact that single crystalline Si nanorods have been shown to possess a significant enhancement in charge carrier mobility as compared to single crystal bulk Si of the same doping level (Cui et al., "Functional Nanoscale Electronic Devices Assembled Using Silicon Nanowire Building Blocks," Science, 2001, vol. 291, pp. 851-853; Cui et al., "High Performance Silicon Nanowire Field Effect Transistors," Nano Lett., 2003, 3(2), p. 149). This, coupled with the fact that it is possible to make nanorod heterostructures (Y. Wu et al., "Block by block growth of single crystalline Si/SiGe superlattice nanowires," Nano Lett. 2002, 2(2), p. 83-86; M.S. Gudiksen et al., "Growth of nanowire superlattice structures for nanoscale photonics and electronics," Nature, 2002, 415, p. 617) and core-shell nanowires (H.M. Lin et al., "Synthesis and Characterization of Core-Shell GaP@GaN and GaN@GaP Nanowires," Nano Lett. 2003, 3(4), 537-541), allows an array of nanorods, with p-n junctions embedded in them, to be used to obtain photovoltaic devices with improved efficiency. This improved efficiency results from improved current density, which is directly proportional to charge carrier mobility. This, in turn, gives rise to an increased open circuit voltage that has a logarithmic relationship with the current. The efficiency of a solar cell is directly proportional to the product of open circuit voltage and current density. The greatly increased surface areas created by a 3-dimensional-like array of 1-dimensional nanostructures produces an effectively larger cell in the same footprint as a traditional 2-dimensional solar cell. Embodiments with long axis p-n junctions along the nanorods essentially create a greater junction area and allow for efficient and fast sweeping of minority carriers across the p-n junctions by the built-in electric field, even if the diffusion length is small, since the carriers are in close proximity to the junction.

Described herein are a number of device embodiments. Several of these embodiments may be used in a combination embodiment, possessing the best attributes of each of the described structures and devices. Some embodiments utilize a flat photovoltaic (PV) cell structure, and phosphor conversion technology can be used to shift the wasted ultraviolet (UV) light and bring it into the visible range. In some such embodiments, a yttrium-aluminum-garnet (YAG)-type phosphor is used.

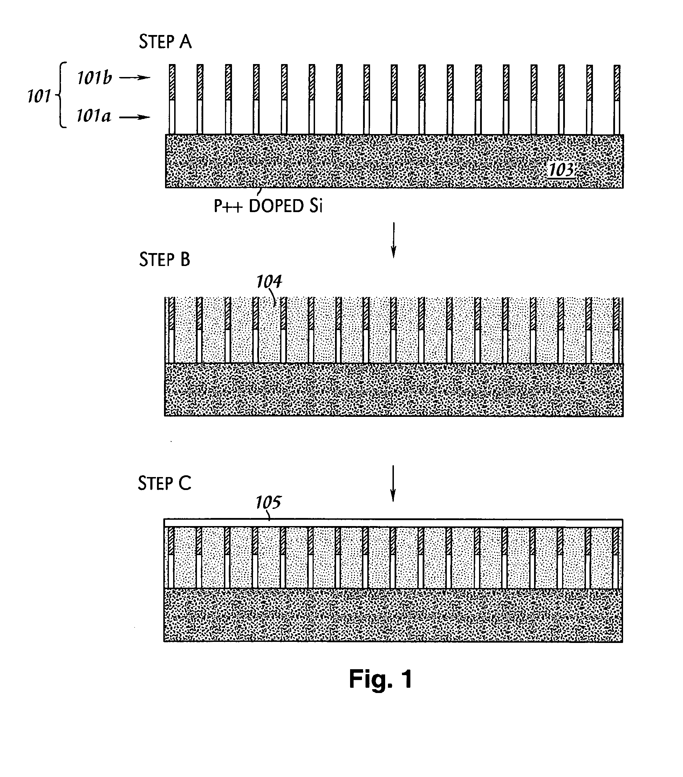

Some embodiments involve the fabrication of doped Si nanorod arrays on a thin Si substrate, as shown in FIGURE 1. Referring to FIGURE 1, in step A, silicon nanorods 101, comprising an n-type nanorod segment (top segment, 101 b) and a p-type nanorod segment (bottom segment, 101 a), are fabricated on a doped Si substrate 103. In step B, a dielectric material 104 is deposited in the space between the nanorods. In step C, a top contact 105 is added. Due to a homoepitaxial relationship, in some embodiments, the nanorods are aligned vertically out of the plane. In some such embodiments, the space between nanorods is filled with a dielectric such as, but not limited to, diamond-like carbon (DLC), spin-on glass, or a CVD oxide, or insulator materials including polymers, and appropriate metal contacts would be deposited on the insulator, to create an accessible p-n junction. In other embodiments, the doping can be reversed such that the top segment is p-doped and the bottom segment is n-doped.

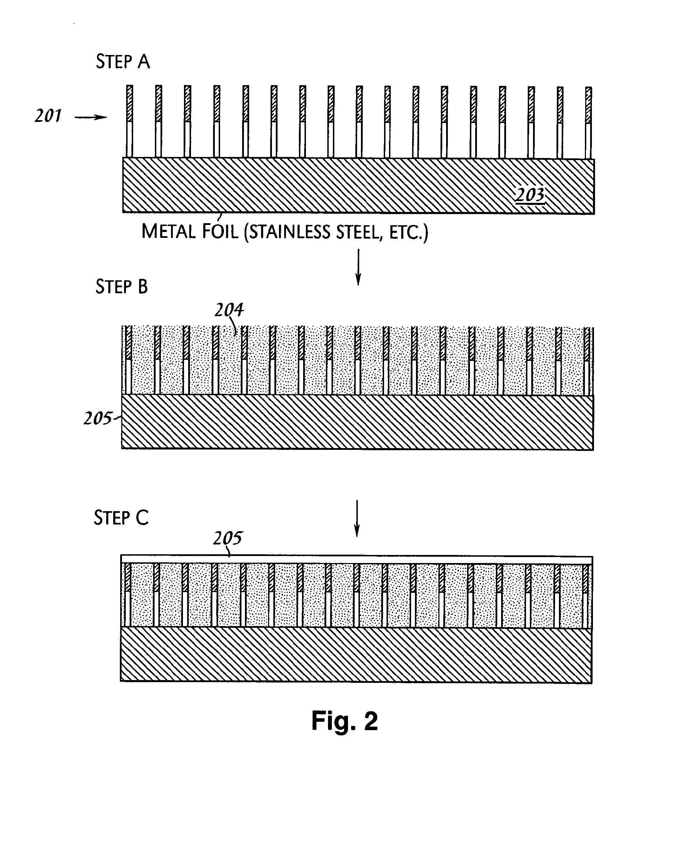

In some embodiments, nanorods are grown on a thin, high-temperature metal foil, wherein the array so formed is filled with a dielectric film, which may be a low coefficient of thermal expansion (CTE) oxide or polymer material, as shown in FIGURE 2. Referring to FIGURE 2, doped nanorods are fabricated on metal foil 203, as shown in step A, dielectric material 204 and a top contact 205 are then added in steps B and C, respectively. This has the advantage of allowing for a flexible PV device. Once fabricated, top contacts can be evaporated onto the device. In some such embodiments, an aluminum (Al) film is deposited on the metal foil. An intermediate metal layer may also be deposited to help form an Ohmic contact to the nanowires. The aluminum film is then anodized in an electrochemical bath to form a nanoporous anodic aluminum oxide (AAO) layer comprising an array of nanoscale columns of diameter 10-150 nm and lengths being approximately 25% greater than that of the original Al film. Nanowires are then grown by CVD from the bottom of each nanopore with the metal foil acting as a catalyst for the growth. Alternatively, a catalyst may be electrochemically deposited at the bottom of the pores to seed growth of the nanowires. Typical CVD conditions are a temperature of 440-670°C in an atmosphere of silane (or chlorosilane) with a flow rate of 10-300 standard cubic centimeters per minute (sccm) and hydrogen with a flow rate of 10-300 sccm for 5-60 minutes.

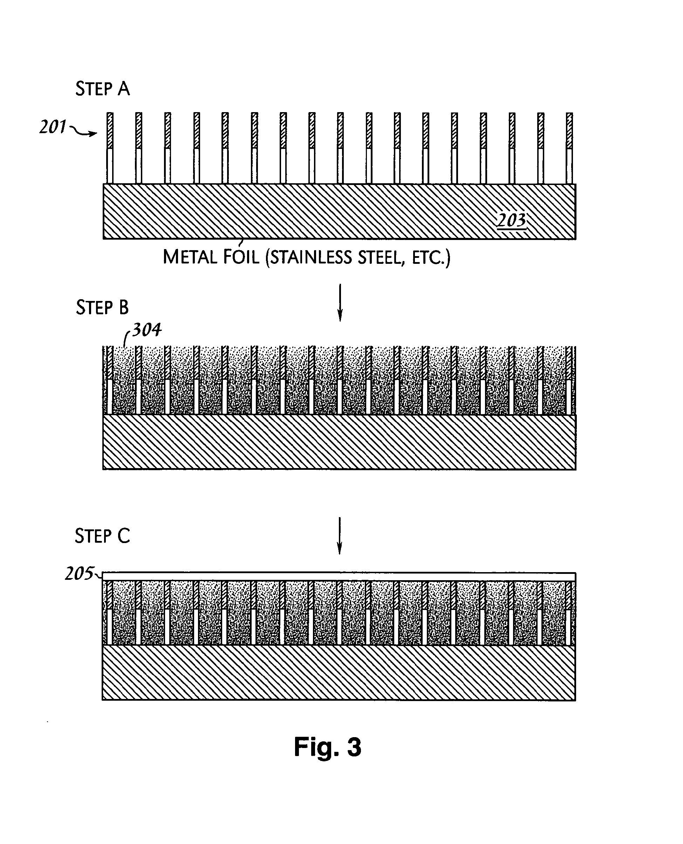

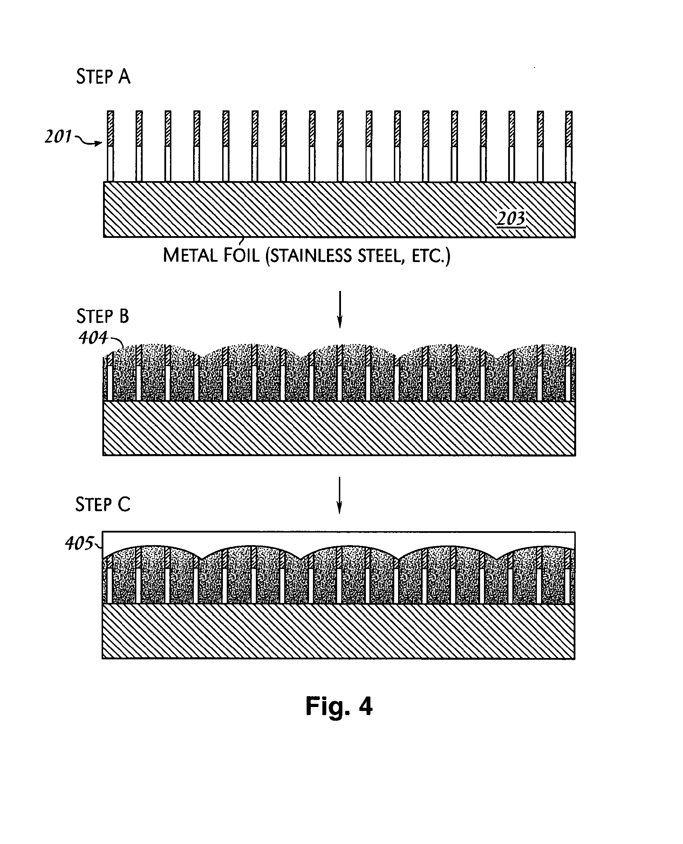

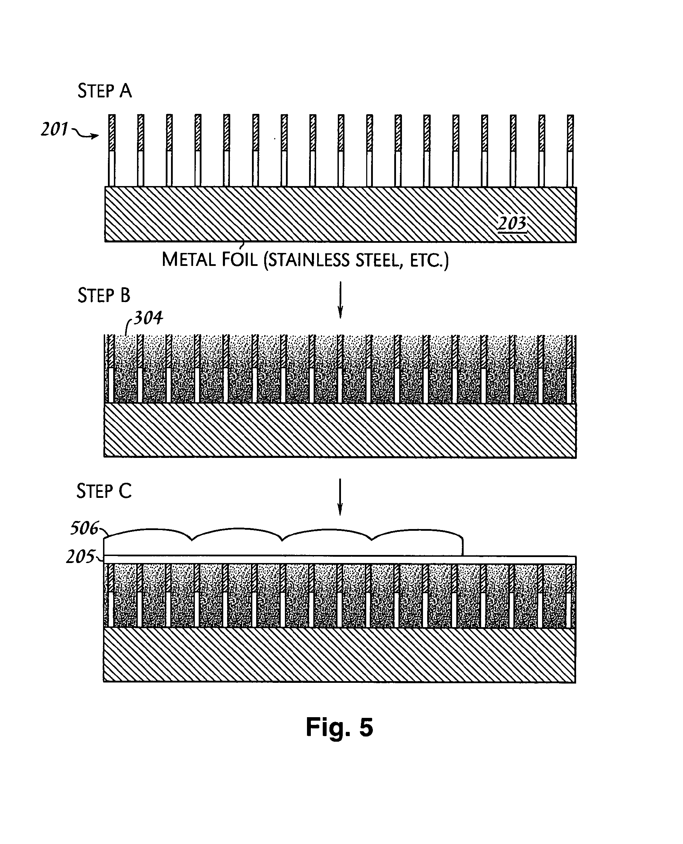

A variant of the above approach is to deposit a dielectric layer 304 with a graded index of refraction such that light is focused onto the sides of the nanorods, as shown in FIGURE 3. This greatly increases the light spectrum of absorption. It is also possible to induce micron scale features in the nanorod/dielectic composite film such that additional optical focusing or collimation is possible, as shown at the interface of dielectric layer 404 and top contact 405 in FIGURE 4. Additionally, an array of micro-lenses 506 may be fabricated directly above the top contact of the PV device, as shown in FIGURE 5, step C.

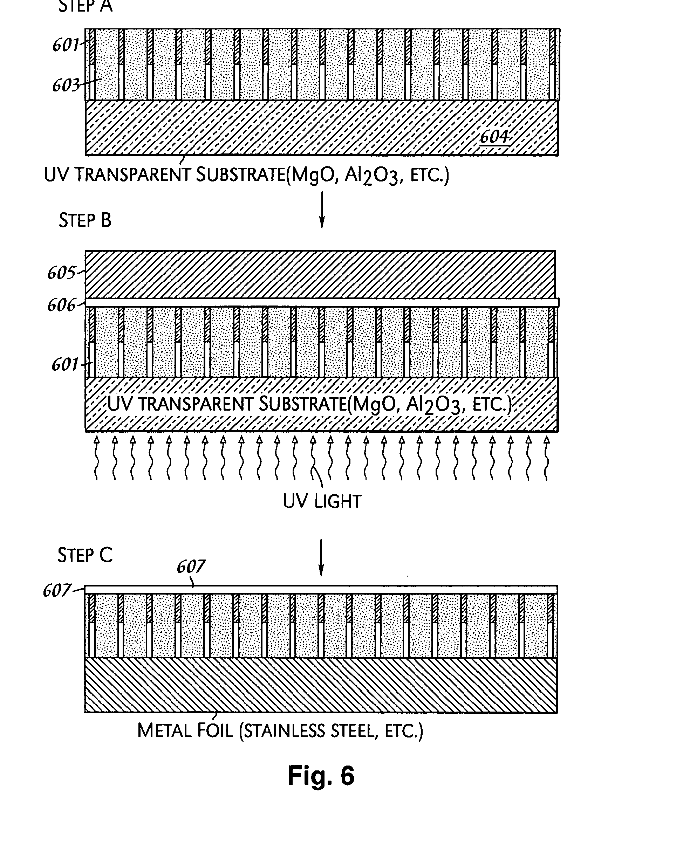

Another embodiment involves growing the nanorod array on a sapphire or MgO substrate, depositing the top contacts, using eutectic bonding (such as Pd-In) to bond the composite film onto a metal foil, and then removing the original growth substrate by a selective etch (if a buffer layer is used) or by using a laser liftoff process, as shown in FIGURE 6. This particular approach is particularly suitable for nanowire arrays comprising gallium nitride (GaN) and related compositions, as they require such substrates for proper nucleation and growth. Referring to FIGURE 6, doped nanorods 601 are fabricated on a UV transparent original substrate 604 with dielectric material 603 filling the space between the nanorods (step A). In step B, a eutectic bond 606 is established between the nanorods 601 and a metal foil 605. This approach is necessary if the leakage current from the previous embodiment is too high, yet mechanical flexibility is desired. Finally, in step C, the original substrate 604 is removed and a top contact 607 is established.

In another embodiment, a metal film is placed on a glass substrate by conventional techniques such as electron beam or thermal evaporation, typically using an adhesion layer such as Ti or Cr. The metal may be Au or another metal that may be used to form an Ohmic contact upon annealing. On top of this metal a Ti layer is deposited in situ, followed by an aluminum film of thickness 1-20 microns. The aluminum film is then anodized in an electrochemical bath to form a nanoporous anodic aluminum oxide (AAO) layer comprising of an array of nanoscale columns of diameter between 10-150 nm and the length being approximately 25% larger than that of the original Al film. Nanowires are then grown by CVD from the bottom of each nanopore with the metal foil acting as a catalyst for growth. Alternatively, a catalyst may be electrochemically deposited at the bottom of the pores to seed growth of the nanowires. It is also possible to use a bilayer metal stack involving a bottom metal contact other than Au onto which the Ti/Au/Ti is deposited.

In another embodiment, a single crystal silicon layer containing a p-n junction is bonded to a glass or metal substrate using well-known bonding techniques such as eutectic bonding (e.g., Pd-In, etc.) with the p-n junction placed closer to the substrate. The silicon layer may be bonded as a thin layer, or it may be thinned, once bonded, to a thickness between 1-20 microns by techniques known to those skilled in the art (e.g., lapping). The thinned Si layer is then wet etched in a hydrofluoric solution comprising AgNO₃ or related compounds to form an array of nanowires. A top conducting transparent oxide is then deposited on top of the nanowire arrays and top metal contacts are deposited. The structure is fabricated such that the back side metal contact is accessible for electrical contact.

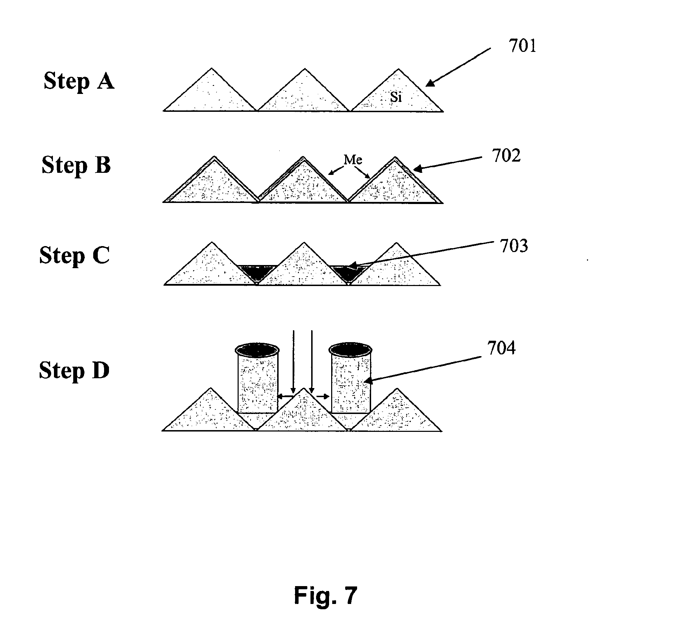

To assist "self-organized" local nucleation and to decrease the reflection of solar cells, in some embodiments, a surface structured with random or regular pyramids 701 is used as a substrate (FIGURE 7, step A), wherein such pyramids 701 are fabricated by conventional anisotropic wet techniques such as KOH etching through masks in a dielectric film such as CVD-deposited SiₓN_{y} or SiO₂. In such embodiments, thin metal (e.g., gold) film 702 is homogenously deposited (e.g., electron beam deposition) on the pyramids, as shown in FIGURE 7, step B. After heating, the metal forms balls easier than when compared to a flat surface. In FIGURE 7, step C illustrates a situation where the balls are gathered at the bottom of the pyramids in wells 703. Afterwards, CVD growth of nanorods 704 continues only locally, as shown in FIGURE 7, step D.

The pyramids between nanowires can help to absorb the incident light parallel to the nanowires (FIGURE 7, step D). If, due to surface tension phenomena, the metal will gather on the tops of the pyramids instead of gathering at the bottom, the above process will still work, and the inverted pyramids between nanowires will help to absorb the light. Thus, even considering different scenarios, the pyramids on the substrate seem to be beneficial for both the local growth of the nanowires and for absorption of light.

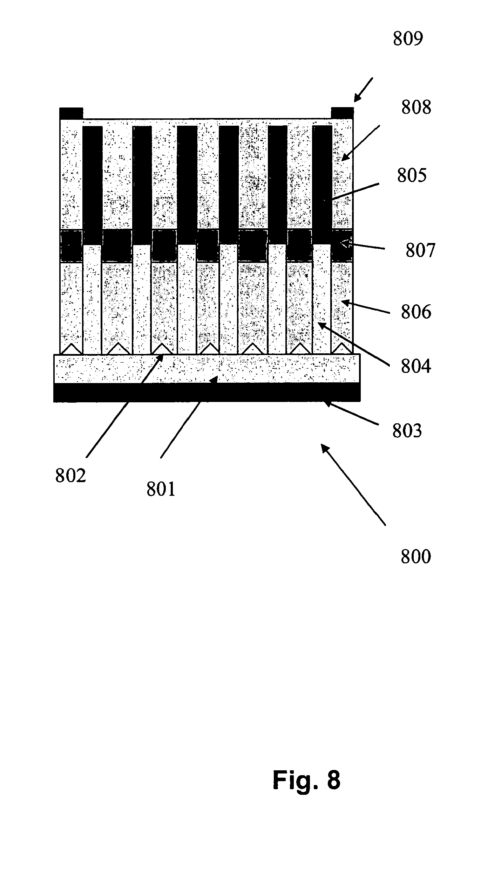

To decrease the resistance of the emitter and base of the nanowire solar cells, in some embodiments, two transparent conductive oxide (TCO) layers (ITO, ZnO:Al, etc.), divided by an insulating layer (SiOₓ, TiOₓ, SiNₓ, etc.), can be applied near the p-n junction, as in device 800 shown in FIGURE 8. Referring to FIGURE 8, on a rear or bottom contact 803 is a substrate 801 on which there are reflecting pyramids 802, doped nanowire segments 804, and a first TCO material 806. An insulating layer 807 is established in the middle of the device, and alternatively doped nanowire segments 805 extend from the doped nanowire segments 804. Between nanowire segments 805 is a second TCO material 808, on top of which are top or front contacts 809.

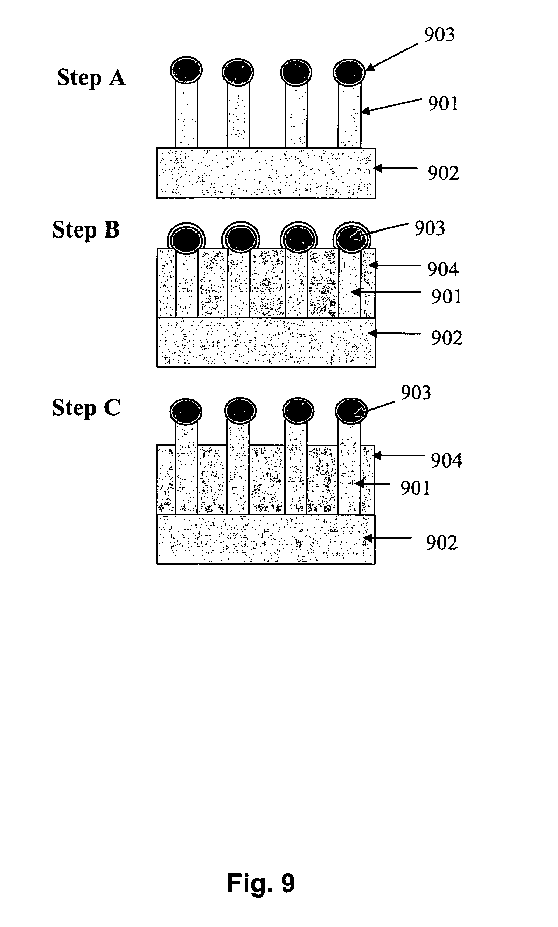

The process illustrated in FIGURE 9 can be used to deposit the corresponding TCO and insulating layers, wherein nanowires 901 are grown on substrate 902 using metal catalyst 903. TCO 904 is deposited between the nanowires 901. Referring to FIGURE 9, after finishing the growth of the major part of the first (n- or p-type) part of the nanowire (step A), the temperature is reduced, growth metal solution is solidified, and the first TCO layer is deposited (step B). The TCO layer will also deposit on the solidified metal, but this layer is expected to crack and disappear during the subsequent heating and melting of the metal underneath. The growth of the nanowire of the same type (n or p) will be continued (step C), and then changed to the opposite type. Afterward, the insulating layer will be deposited in a manner similar to that described above. Finally, after finishing the growth of the rest of the nanowire, the second TCO layer will be deposited.

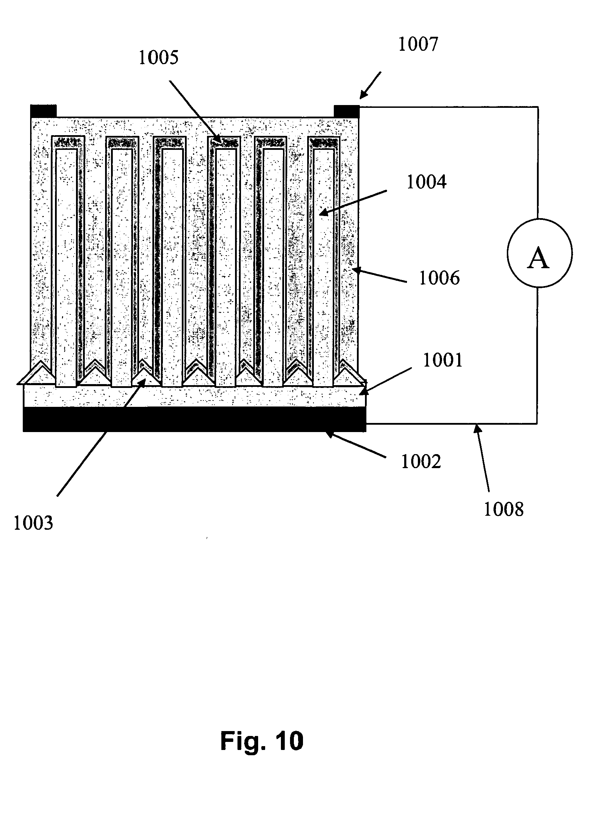

To decrease the probability of the nanowire bending, in some embodiments growth in an electric field is employed, as in the nanowire cell shown in FIGURE 10, in which substrate 1001 is in contact with rear contact 1002. On substrate 1001 are reflecting pyramids 1003, crystalline silicon nanorods (p or n) 1004, and an amorphous silicon coating (n or p) 1005 on the silicon nanorods 1004. TCO material 1006 exists between the nanorods and front contacts 1007 are positioned an top of the device. Front and rear contacts 1007 and 1002 allow connection of the photovoltaic device to an external circuit 1008.

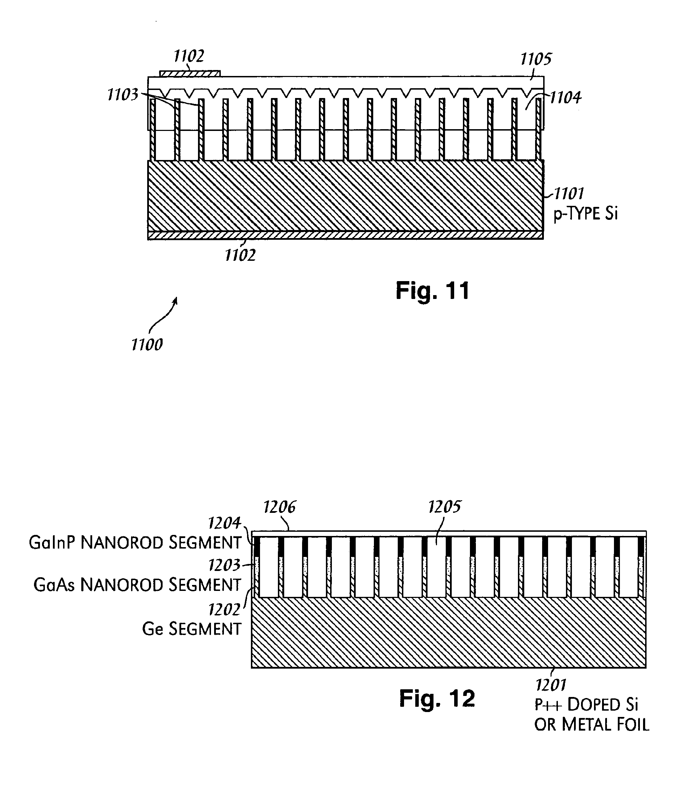

Another embodiment is the nano-hybrid photovoltaic cell 1100 shown in FIGURE 11. Recently, hybrid crystalline-amorphous silicon solar cells have been shown to possess relatively high efficiencies (up to ~21%) owing to the bandgap difference and passivating effect of the amorphous film on the bulk substrate (United States Patent No. 4,496,788). Some of the embodiments described herein take advantage of these effects. In some such embodiments, p-type Si nanorods 1103 are fabricated on a p-type silicon substrate 1101. An n-type amorphous silicon layer 1104 is positioned conformally on top of the Si nanorods 1103 by plasma enhanced chemical vapor deposition, wherein layer 1104 fully or partially coats the full or partial length of the nanorods within the array and may or may not coalesce to form a continuous layer. A top layer 1105 of conductive transparent material (e.g., indium-tin-oxide glass) is positioned on top of the amorphous silicon layer 1104. Metal contacts 1102 (e.g., Al, Au) permit connection of the device to an external circuit.

Another embodiment similar to the preceding embodiment is the conformal deposition of crystalline material of n-type doping on top of crystalline p-type nanowires. The resulting structure has the advantage that any generated carriers are quickly swept across the junction due to its close proximity to the generating region, even if the carrier lifetime is low.

One approach to increasing the efficiency of solar cells is by monolithically integrating materials with different bandgaps to increase the amount of the solar spectrum absorbed, as compared to a single bandgap junction. This approach has produced record efficiency solar cells of ~37% under 5000 sun illumination (R.R. King et al., "Lattice-matched and metamorphic GalnP/GalnAs/Ge concentrator solar cells," Conference Record of the Twenty-Ninth IEEE Photovoltaic Specialists Conference, 2002, Vol. 1, pp. 622-625). One problem with epitaxial growth of such heterogeneous semiconductor films grown on one another is that the mismatch in lattice parameter and thermal expansion coefficients leads to the introduction of dislocations at the interfaces, which are deep level traps that degrade the lifetime of carriers. Growth of such heterostructures in the form of nanowire arrays does not impose a biaxial stress and thus it is possible to produce structures with reduced defects as well as increase the critical thickness for the introduction of dislocations (A. Alizadeh, et al., "Templated Wide Bandgap Nanostructures," J. Appl. Phys., 2004, vol. 95, no. 12, pp. 8199-8206). Thus, in some embodiments, the photovoltaic devices comprise heterojunction nanorod arrays. This is illustrated in FIGURE 12, wherein device 1200 comprises a substrate 1201 made of p-doped (or n-doped) Si, degenerately doped Si, p-doped (or n-doped) Ge, GaAs, glass, or metal foil. Nanorods are synthesized on top of the substrate by CVD using epitaxial growth or the nanotemplate approach described above such that each nanorod comprises a Ge segment 1202, a GaAs segment 1203, and a GaIP₂ segment 1204. The gas used for Ge growth is germane, followed by trimethylgallium and aresene for the GaAs growth, and trimethylgallium, trimethylindium, and phosphene for the GaAs growth. Dielectric material 1205 (e.g., SiOx, Si-N, polymer, etc.) is dispersed within the array of nanorods. A top layer 1206 of conductive transparent material, such as ITO glass, resides on top of the array of nanorods. In some embodiments, tunneling barriers are grown between the Ge-GaAs and GaAs-GalnP₂ segments, respectively. In such a manner, it is possible to build additional stacks of differing bandgap material with the largest bandgap placed at the top of the stack and the smallest bandgap at the bottom of the stack closest to the substrate.

In another embodiment, a metal film is placed on a semiconductor, glass, or metal substrate by conventional techniques such as electron beam or thermal evaporation, typically using an adhesion layer such as Ti or Cr. The metal may be Au or another metal that may be used to form an Ohmic contact upon annealing. On top of this metal, a Ti layer is deposited in situ, followed by an aluminum film of thickness 1-20 microns. The aluminum film is then anodized in an electrochemical bath to form a nanoporous anodic aluminum oxide (AAO) layer consisting of an array of nanoscale columns of diameter between 10-150 nm and the length being approximately 25% greater than that of the original Al film. Nanowires comprising both a p and an n segment are then grown by CVD from the bottom of each nanopore with the metal foil acting as a catalyst for the growth. For silicon nanowire diodes, doping is achieved by use of a boron source (e.g. trimethylboron) for the p-type segment and a phosphorus source (e.g. phosphine) for the n-type segment. Alternatively, a catalyst may be electrochemically deposited at the bottom of the pores to seed growth of the nanowires. Other semiconductor nanowire diodes may be grown, including GaAs, Ge, InP, or GaP. It is also possible to use a bilayer metal stack involving a bottom metal contact other than Au onto with the Ti/Au/Ti is deposited. The length of each nanowire diode within the nanopores is shorter than the height of the nanoporous AAO template, typically not greater than 1 micron. The remaining volume of the nanopores is filled with metal such as Au, Ni, or Pt using electrodeposition to form long metal nanowires segments on top of a short semiconducting nanowire diode segment. The structure is then coated with a TCO to make electrical contact to the metal nanowires and large metal pads are placed on the TCO. This results in a nanoscale analog of the so-called optical rectenna (rectifying antenna) solar cell concept that was originally proposed in the 1960's and that is theoretically capable of efficiencies as high as ~85% (W.C. Brown, IEEE Transactions on Microwave Theory and Techniques, 1984, vol. MTT-32, p. 1230).

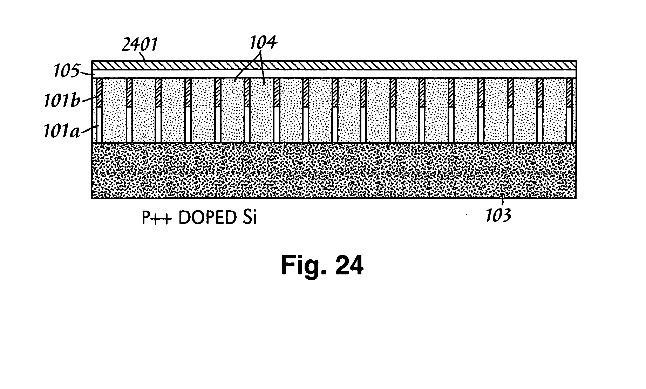

The use of phosphors, as described above, can also be used to enhance conventional multi-crystalline solar cells, the surface of which cannot be textured to increase absorption and such cells typically having only about 14% conversion efficiency for a large area (225 cm²). Such phosphor-based enhancement can produce efficiencies that exceed 18% in such conventional solar cells, with very little or no additional cost. Even with this modest increase in energy conversion efficiency to 18% on low cost, high throughput material, solar electricity can be competitive with conventional grid electricity. Accordingly, in some embodiments, phosphors may be deposited on the PV device in order to help capture additional portions of the electromagnetic (EM) spectrum. FIGURE 24 illustrates such a placement, wherein phosphor layer 2401 is situated on top of the device shown in FIGURE 1. Multi-nanotube/nanorod materials on a single substrate, may be used, as the CTE-induced stresses are eliminated due to the narrowness of the nanotubes actually connected to the substrate. This is a pixilated format heretofore unknown in the art. Other embodiments involve growth of multi-layer nanorods in which the bandgap is graded from one in the UV range on the top to one in the near-infrared (NIR) range on the bottom. This allows for collection of light from energy regimes that were previously unobtainable. Additionally, it is expected that misfit strain would be relieved due to the fact that the wires are in the nanoscale regime, thus alleviating such strain that typically results in thin film heteroepitaxy of disparate materials and which typically leads to cracking or poor device performance due to materials defects.

In some embodiments, the present invention is directed to a photovoltaic device comprising: (a) a substrate; (b) a first region comprising an array of branched nanostructures of semiconducting material positioned on the substrate, wherein charge separating junctions exist within such branched nanostructures (K.A. Dick et al., "Synthesis of branched "nanotree" by controlled seeding of multiple branching events," Nature Materials, 2004, Vol. 3, pp. 380-384); (c) a second region comprising a conductive transparent material residing as a layer on top of the first region; and (d) top and bottom contacts operable for connecting the device to an external circuit; wherein the device is comprised exclusively of inorganic components.

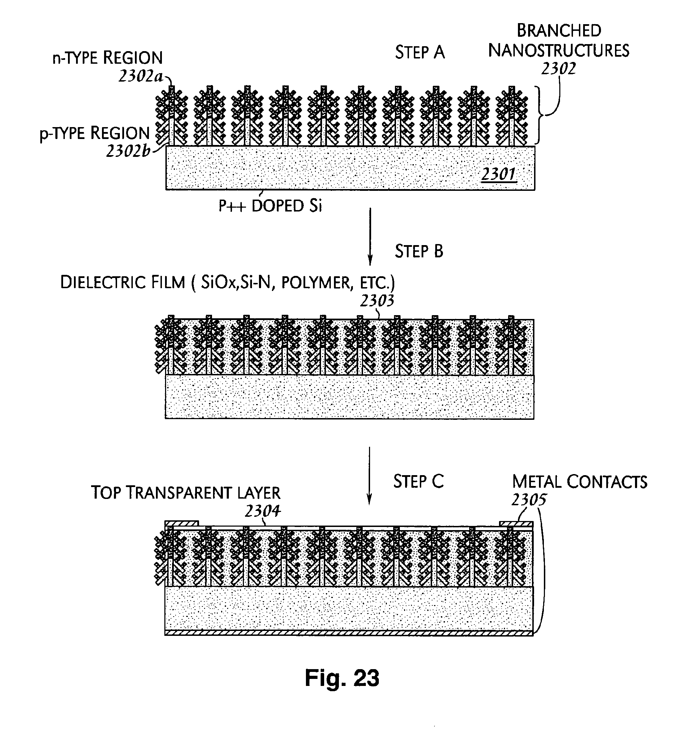

FIGURE 23 illustrates the fabrication of one such above-described PV device, in accordance with an embodiment of the present invention. Referring to FIGURE 23, branched nanostructures 2302 are grown on doped Si substrate 2301, as shown in Step A. Such branched nanostructures 2302 comprise a p-type nanostructure region 2302b and an n-type nanostructure region 2302a. A dielectric material 2303 is then deposited, as shown in Step B. Finally, in Step C, transparent top layer 2304 and metal contacts 2305 are added.

The materials used for the above-described photovoltaic devices comprising branched nanostructures are the same as those used for the photovoltaic devices comprising 1-dimensional nanostructures, and such devices also comprise metal contacts for connecting the device to an external circuit.
Additionally, structured surfaces are used in some embodiments. In some embodiments, such branched "tree-like" nanostructures allow for better light harvesting. Generally, at least some of the branched nanostructures comprise a doping selected from the group consisting of p-doping, n-doping, and combinations thereof. Generally, the density of the branched nanostructures with a photovoltaic device is such that they occupy a volume of the first region that is between about 5 percent and about 100 percent.

The present invention has the potential to provide PV devices with efficiencies greater than 20-60%, which is 2-5 times more efficient than existing technologies. Such efficiency enhancement may revolutionize how solar technology is utilized commercially. Additionally, lower weight and lower PV cell heating, due to more efficient cell structures, are great advances over existing technology.

The present invention provides silicon nanorod enhancements to existing solar cells. Silicon nanorod p-n junctions can be created on or within the nanorods. Graded index material can be used in embodiments to optimize the spectral response of the cell. Mixed nanorod embodiments, using other than exclusively silicon nanorods may also be used. This may include selenium nanorods, tungsten nanorods, and other photonic materials to broaden the spectrum and enhance the absorption area of the cells. It is also believed that the PV cells will not fail in the ways that the current day technologies fail, e.g., light-induced degradation and contact failures.

The following examples are included to demonstrate particular embodiments of the present invention. It should be appreciated by those of skill in the art that the methods disclosed in the examples that follow merely represent exemplary embodiments of the present invention. However, those of skill in the art should, in light of the present disclosure, appreciate that many changes can be made in the specific embodiments described and still obtain a like or similar result without departing from the spirit and scope of the present invention.

### EXAMPLE 1

This example illustrates an embodiment where wet etching is used to produce nanowire arrays for use in PV devices of the present invention.

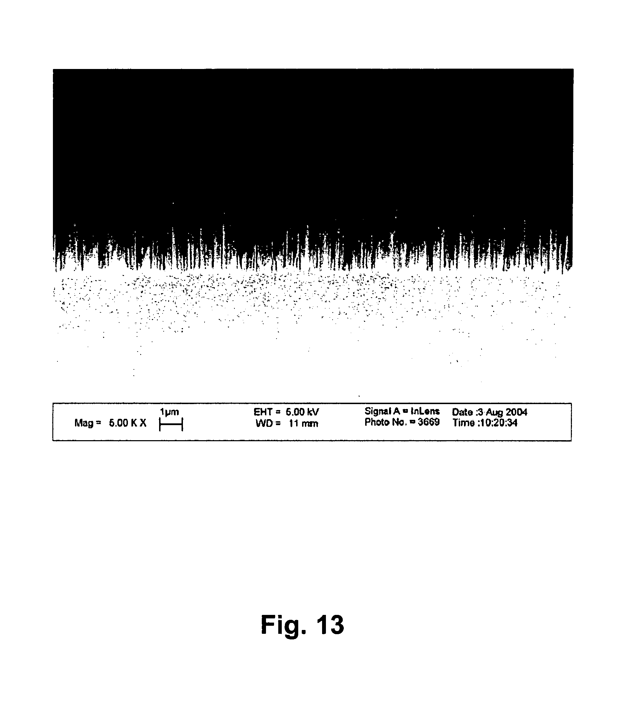

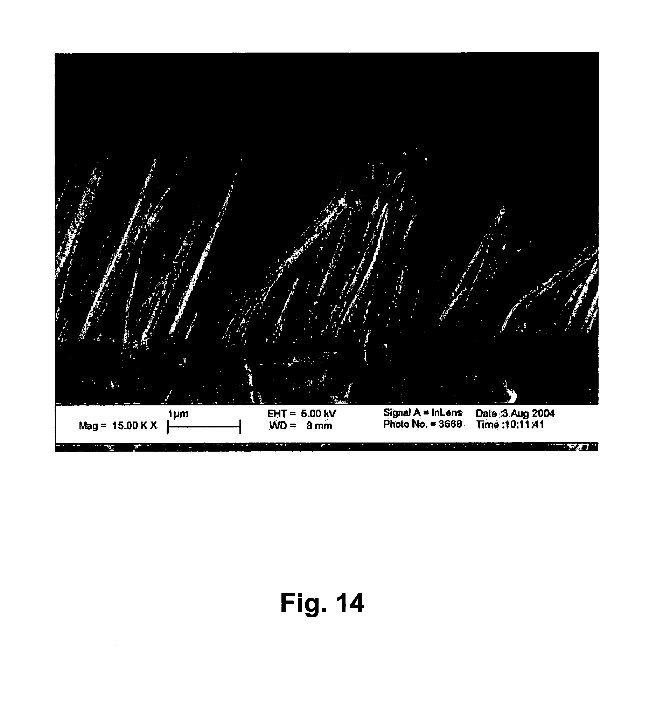

Wet etching of bulk or thin film substrates to produce nanowire arrays may be achieved as follows. A bulk Si substrate is cleaned using known procedures. The substrate is then place in a solution comprising 1 M AgNO₃ in HF. The temperature of the bath may be room temperature or as high as 80°C. This process leads to the precipitation of nanoscale Ag dendrite particles on the surface. The nanoscale particles allow for directional electric fields perpendicular to the surface of the substrate to form that are concentrated at the nanoscale. This permits a galvanic process to occur at this length scale. An illustrative example of a nanowire array formed by wet etching on <100> Si wafers is shown in the scanning electron micrograph (SEM) of FIGURE 13. Nanowire arrays on <111> Si substrates are formed at an angle of - 45 degrees to the substrate surface, as shown in the SEM image of FIGURE 14.

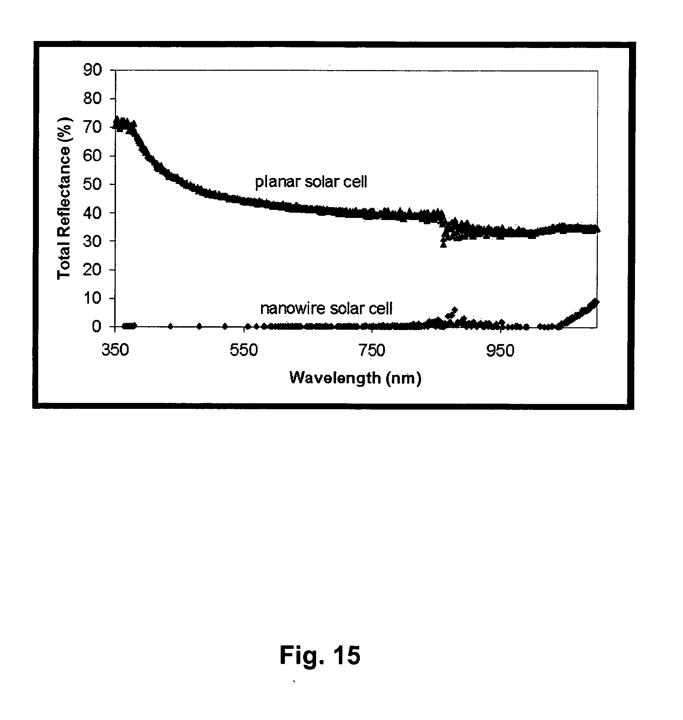

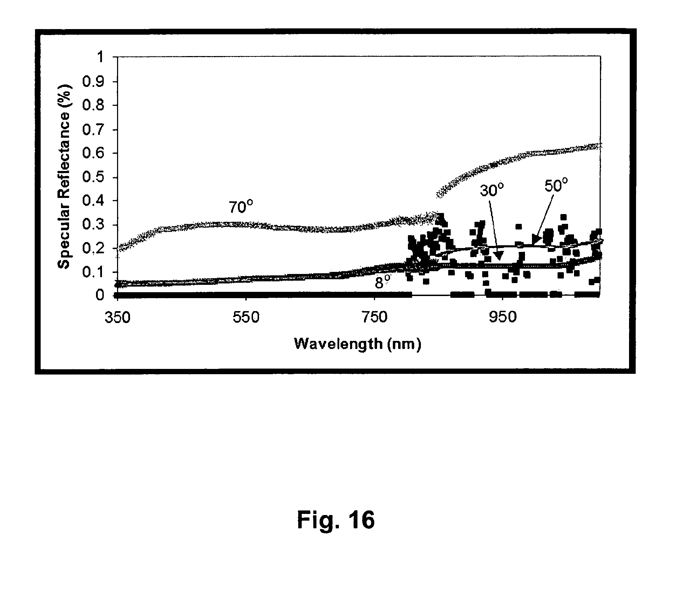

A particularly attractive feature of these nanowire arrays is that the optical reflectance is significantly reduced, as compared to a planar surface. Total reflectance is below 5% for almost the entire wavelength range of relevance to solar cells (300-1100 nm), as shown in FIGURE 15, and specular reflectance is below 1% for angles ranging from 8-70 degrees, as shown in FIGURE 16.

### EXAMPLE 2

This example illustrates CVD growth of aligned nanowire arrays for use in PV devices of the present invention.

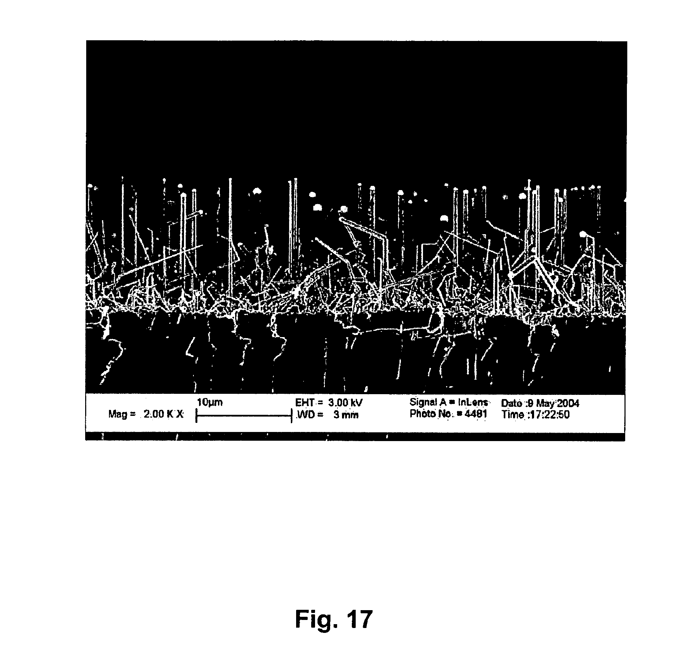

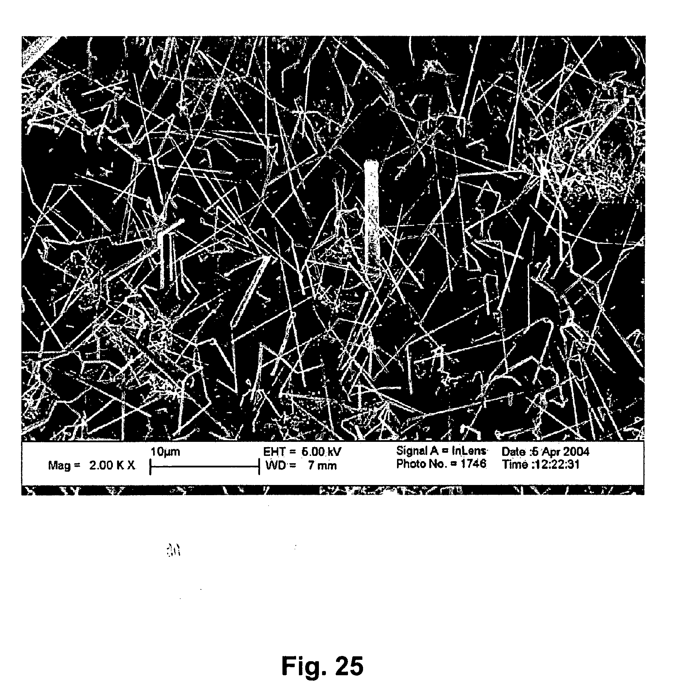

Aligned nanowire arrays may be grown by CVD by first cleaning the substrate using known procedures. In the case of growth on Si, the substrate is also etched in HF to remove the native oxide. The substrate is then immediately placed inside the deposition system (evaporation or sputtering) that will place a thin metal catalyst layer onto the surface. The catalyst may also be deposited from solution by spin coating. The typical thickness of the catalyst layer is 1-30 nm. The metal-coated substrate is then place in a horizontal low pressure CVD (LPCVD) furnace and heated to between 400-700°C. Once the set temperature is attained, hydrogen and silane flow at rates of between 1 and 300 sccm for 5- 60 minutes. FIGURE 17 is an SEM image depicting an example of such a CVD-produced Si nanowire array grown at 560°C. FIGURE 25 is an SEM image depicting an example of CVD-produced Si nanowire array grown in a nanoporous anodic aluminum oxide (AAO) template.

### EXAMPLE 3

This example illustrates the fabrication of a solar cell device in accordance with an embodiment of the present invention.

A p-type silicon substrate comprising a thin region of phosphorus (by ion implantation or diffusion) to form a thin n-type region on the top surface of the substrate is coated with silicon nitride on both sides. The p-n junction is located 0.5 - 2 microns below the surface. The top nitride layer is removed by reactive ion etching. The substrate is then wet etched in AgNO₃/HF to form a nanowire array on the top surface. The silicon nitride on the back side is then removed by reactive ion etching and metal (AI) is deposited on the backside.

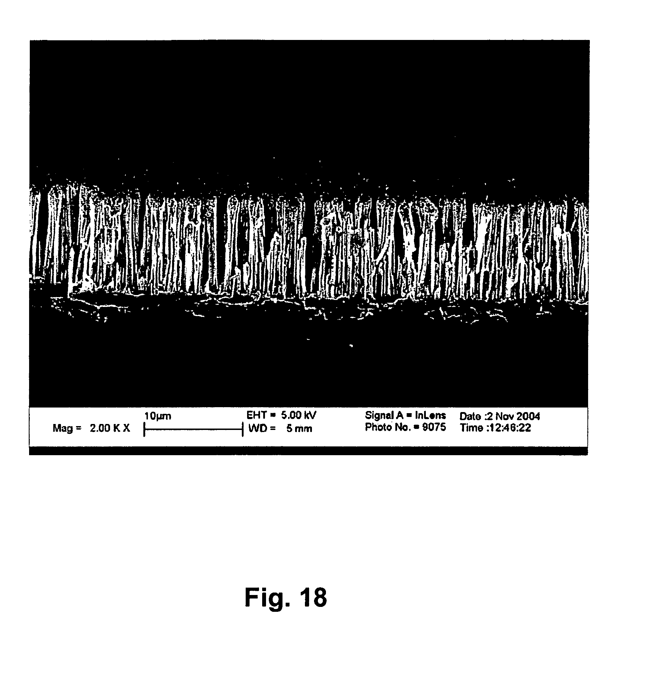

The wafer is then annealed at 400°C in a hydrogen atmosphere. A TCO such as ITO is then deposited onto the top nanowire surface and metal patterns are deposited on the ITO through a shadow mask. FIGURE 18 is an SEM image depicting such a solar cell in cross section.

### EXAMPLE 4

This example illustrates operational characterization of solar cell devices, such devices being representative embodiments of the present invention.

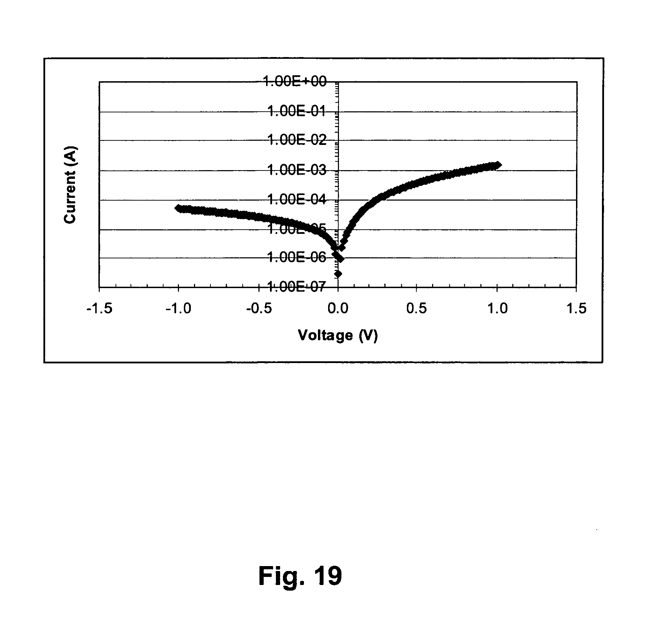

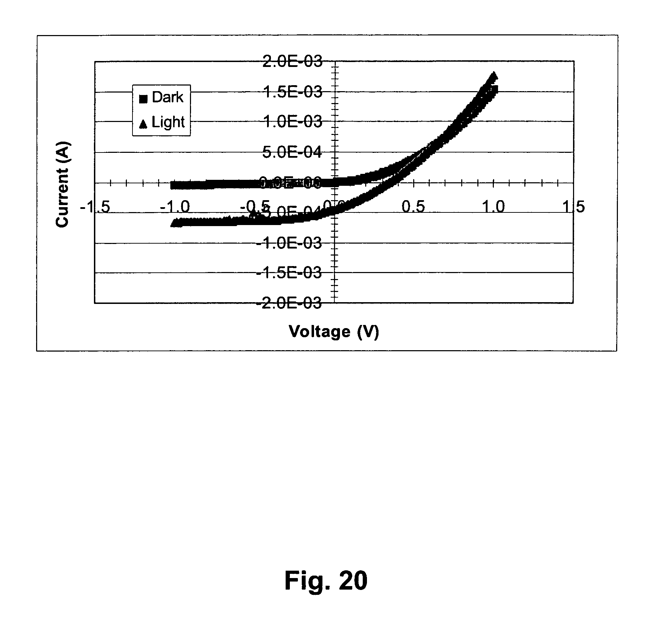

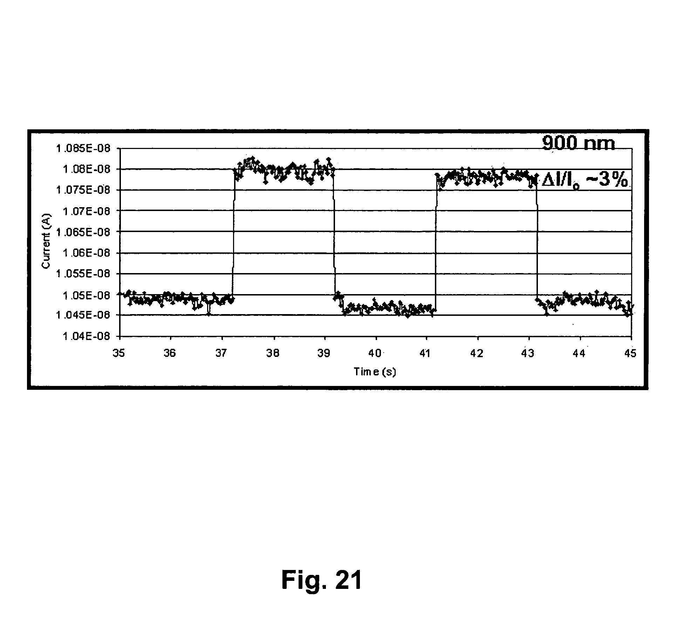

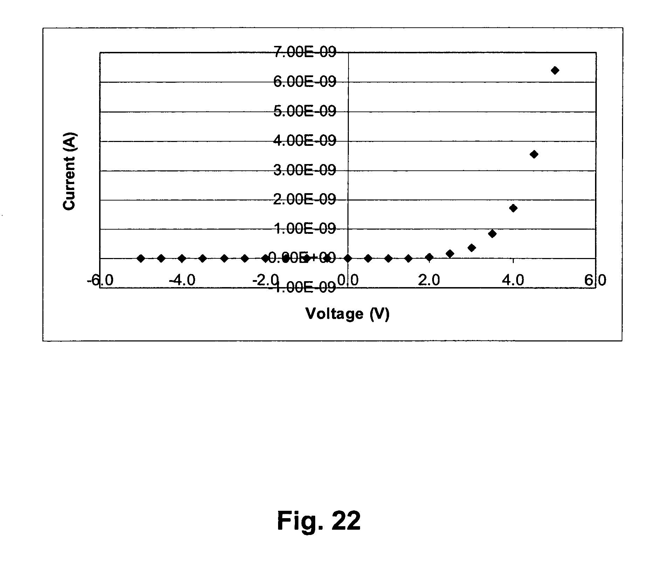

Nanowire solar cells were characterized by irradiation with a broadband light source. FIGURE 19 shows the dark current voltage (I-V) curve of a nanowire array solar cell with diode behavior evident. FIGURE 20 shows both the dark I-V curve and the I-V characteristics under irradiation of a ceramic metal halide lamp. The curve shifts downward into the fourth quadrant, which means the solar cell can produce power. The short circuit current is approximately 1 mA/cm² and the open circuit voltage is -380 mV. The photoresponse of individual nanowires has been measured (FIGURE 21) with typical photocurrents of 10-200 pA. The I-V curve of an individual Si nanowire containing a p-n diode is shown in FIGURE 22.

In summary, the present invention is directed to photovoltaic devices comprising nanostructured materials, wherein such photovoltaic devices are comprised exclusively of inorganic materials/components. Depending on the embodiment, such nanostructured materials are either 1-dimensional nanostructures or branched nanostructures, wherein such nanostructures are used to enhance the efficiency of the photovoltaic device, particularly for solar cell applications. Additionally, the present invention is also directed at methods of making and using such devices.

## Claims

1. A photovoltaic device comprising:
a) a substrate (103);
b) a first region (101a) comprising an array of 1-dimensional nanostructures positioned on the substrate in a substantially vertical orientation;
c) a second region (101b) residing on top of the first region such that contact of the first and second regions forms at least one charge separating junction;
d) a third region (105) comprising a conductive transparent material residing as a layer on top of the second region; and
e) top and bottom contacts operable for connecting the device to an external circuit, wherein the bottom contact is in electrical contact with the first region and the top contact is in electrical contact with the second region;
wherein the first (101a), second (101b), and third (105) regions are comprised exclusively of inorganic components.

2. The photovoltaic device of claim 1, wherein the second region (101 b) exists as extensions of the 1-dimensional nanostructures of the first region (101 a), and wherein the first and second regions collectively form an array of 1-dimensional nanostructures, such that charge separating junctions exist within the 1-dimensional nanostructures.

3. The photovoltaic device of claim 2, wherein at least some of the 1-dimensional nanostructures comprise multiple charge separating junctions.

4. The photovoltaic device of claim 2, wherein at least one of the first and second regions comprise heterogeneous sub-regions, and wherein the sub-regions are heterogeneous by virtue of a property selected from the group consisting of heterogeneous doping, heterogeneous composition, and combinations thereof.

5. A method of making a photovoltaic device comprising the steps of:
a) forming a first region on a substrate, wherein the first region comprises an array of 1-dimensional nanostructures that are positioned on the substrate in a substantially perpendicular orientation relative to the substrate;
b) establishing a second region of material on top of the first region such that contact of the first and second regions forms at least one charge separating junction;
c) providing a third region, comprising an optically transparent conductive material, as a layer on top of the second region; and
d) providing top and bottom contacts operable for connecting the device to an external circuit, wherein the bottom contact is in electrical contact with the first region and the top contact is in electrical contact with the second region.

6. The method of claim 5, wherein the step of forming the first region comprises a wet etching of a semiconductor material.

7. The method of claim 6, wherein the steps of forming the first region and establishing the second region comprise wet etching of a planar silicon p-n junction with an aqueous hydrofluoric acid solution comprising silver nitrate to provide a first region of doped silicon nanowires arrayed on a commonly doped silicon substrate and a second region of alternatively doped silicon nanowires, the alternatively doped silicon nanowires being extensions of the doped silicon nanowires of the first region and collectively forming an array of heterojunction 1-dimensional silicon nanostructure wires.

8. The method of claim 5, wherein the step of forming a first region on a substrate further comprises the steps of:
a) establishing metal catalyst nanoparticles on the substrate; and
b) growing 1-dimensional nanostructures from the metal catalyst nanoparticles using a deposition method selected from the group consisting of chemical vapor deposition, laser ablation, molecular beam epitaxy, atomic layer deposition, supercritical point chemical vapor deposition, plasma enhanced chemical vapor deposition, low pressure chemical vapor deposition, sputtering, evaporation, and combinations thereof.

9. The method of claim 8, wherein the step of establishing metal catalyst nanoparticles on the substrate further comprises the steps of:
a) depositing a metal catalyst film on the substrate; and b) annealing of the metal catalyst film to form metal catalyst nanoparticles.

10. A photovoltaic device comprising:
a) a substrate (2301);
b) a first region (2302) comprising an array of branched nanostructures of semiconducting material positioned on the substrate, wherein charge separating junctions exist within such branched nanostructures;
c) a second region (2304) comprising a conductive transparent material residing as a layer on top of the first region; and
d) top and bottom contacts (2305) operable for connecting the device to an external circuit;
wherein the first and second regions are comprised exclusively of inorganic components.
